# EUROPEAN PATENT APPLICATION

(11) **EP 4 443 668 A1**
(43) Date of publication of application: **09.10.2024**
(21) Application number: 22914298.9
(22) Date of filing: 15.12.2022
(51) Int. Cl.: H01R 13/631, H01R 24/00

(54) **GUIDE CONNECTION STRUCTURE AND ELECTRONIC APPARATUS**

(30) Priority: 28.12.2021 CN 202123338957 U
(71) Applicant: Huawei Technologies Co., Ltd., Shenzhen, Guangdong 518129 (CN)
(72) Inventor: FAN, Jinchun, Shenzhen, Guangdong 518129 (CN); JIN, Peng, Shenzhen, Guangdong 518129 (CN); ZHANG, Shijun, Shenzhen, Guangdong 518129 (CN)
(74) Representative: Isarpatent
(86) International application number: PCT/CN2022/139296
(87) International publication number: WO 2023/125043

(57) **Abstract**

A guiding connection structure and an electronic device are provided. The guiding connection structure is configured to implement mutual guiding connection between a plug-in part installed on a first object and a plug-in part installed on a second object. The guiding connection structure includes a guide pin (152) and a guide sleeve (203) for guiding insertion of the guide pin (152). The guide pin (152) is installed on the first object, and the guide sleeve (203) is installed on the second object. An inner hole path of the guide sleeve (203) includes a variable-diameter section. A hole diameter of the variable-diameter section gradually increases from one end (2033) of the variable-diameter section to the other end (2034) of the variable-diameter section. When the guide pin (152) is inserted into the guide sleeve (203), the guide pin (152) is inserted into the other end (2034) of the variable-diameter section from the one end (2033) of the variable-diameter section. The guiding connection structure can improve system guiding precision.

## Description

This application claims priority to Chinese Patent Application No. 202123338957.1, filed with the China National Intellectual Property Administration on December 28, 2021 and entitled "GUIDING CONNECTION STRUCTURE AND ELECTRONIC DEVICE", which is incorporated herein by reference in its entirety.

### TECHNICAL FIELD

This application relates to the field of electronic devices, and in particular, to a guiding connection structure and an electronic device.

### BACKGROUND

A typical communication device includes several parts, such as a subrack, a pluggable functional module, a backplane, a power module, and a fan module. A communication function of the communication device is mainly implemented by the pluggable functional module and the backplane. Interconnection and transmission of a communication signal depend on accurate and in-place installation of connectors on the pluggable functional module and the backplane.

To implement a larger service volume in a single subrack, a high-speed backplane connector tends to be integrated and complex and have high density within a limited spatial size. Under a process condition in the conventional technology, robustness, a tolerance capability, and an external comprehensive stress resistance capability of a connector tend to be degraded.

With continuous evolution of a product rate from 56 G to 112 G, an overall system design becomes increasingly complex. A size and a weight of the pluggable functional module continuously increase, and a force applied to high-speed connectors during fitting and installation becomes increasingly complex.

Mainstream communication device manufacturers and connector manufacturers in the industry are all faced with the following cases: High-speed connector fitting scenarios tend to be complex and worsened, a guiding capability is insufficient during fitting and plugging between connectors, serious misalignment occurs, and the like. Consequently, during plugging between the pluggable functional module and the backplane of the subrack, pins of a circuit connector are not aligned, a housing is damaged, a pin is damaged, the housing is detached, a plugging force is large, or other problems occur. This leads to a device exception or even damage and a failure of operation.

Therefore, overall system guiding precision during plugging between the pluggable functional module and the backplane of the subrack directly determines accuracy of alignment during fitting and plugging between connectors. Higher system guiding precision and higher accuracy of alignment between connectors can better ensure reliable operation and ease of maintenance of the communication device.

### SUMMARY

Embodiments of this application provide a guiding connection structure, to improve system guiding precision and ensure accuracy of alignment between connectors.

To achieve the foregoing objective, the following technical solutions are used in embodiments of this application.

According to a first aspect, this application provides a guiding connection structure, configured to implement mutual guiding connection between a plug-in part (for example, a connector) installed on a first object (for example, a backplane) and a plug-in part installed on a second object (for example, a pluggable module). The guiding connection structure includes a guide pin and a guide sleeve for guiding insertion of the guide pin. The guide pin is installed on the first object, and the guide sleeve is installed on the second object. An inner hole path of the guide sleeve includes a variable-diameter section. A hole diameter of the variable-diameter section gradually increases from one end of the section to the other end of the section. When the guide pin is inserted into the guide sleeve, the guide pin is inserted into the other end of the variable-diameter section from the one end of the variable-diameter section.

According to an implementation of this application, a fine guide hole (an end of the variable-diameter section) is closer to a fastened end of the guide pin and an initial fitting end face between a male connector and a female connector. A distance between the fine guide hole and an initial contact end face between the male connector and the female connector is reduced. This can effectively alleviate guiding misalignment between the male connector and the female connector that is caused by bending and deformation of the guide pin on the backplane under effect of gravity of the pluggable functional module, and guiding misalignment caused by an extreme plugging deflection angle of the pluggable functional module on a guide rail in a subrack, and improve a second-stage system guiding capability, for example, improve the system guiding capability by more than 10%.

In a possible implementation of the first aspect, the one end of the variable-diameter section includes a fine guide hole, and a hole diameter of the fine guide hole adapts to an outer diameter of the guide pin, so that in a state in which the guide pin is inserted into the fine guide hole, accurate plugging between the plug-in part of the first object and the plug-in part of the second object is implemented.

In a possible implementation of the first aspect, the inner hole path of the guide sleeve further includes an equal-diameter section. A hole diameter of the equal-diameter section remains the same from one end of the section to the other end of the section. The other end of the equal-diameter section is connected to the one end of the variable-diameter section. When the guide pin is inserted into the guide sleeve, the guide pin is inserted into the other end of the equal-diameter section from the one end of the equal-diameter section. The hole diameter of the equal-diameter section is equal to a hole diameter of the one end of the variable-diameter section, and adapts to the outer diameter of the guide pin, so that in a state in which the guide pin is inserted into the equal-diameter section, accurate plugging between the plug-in part of the first object and the plug-in part of the second object is implemented.

In a possible implementation of the first aspect, the inner hole path of the guide sleeve further includes a tapered hole section for guiding insertion of the guide pin into the equal-diameter section, a hole diameter of the tapered hole section gradually decreases from one end of the section to the other end of the section, and the other end of the tapered hole section is connected to the one end of the equal-diameter section.

In a possible implementation of the first aspect, a hole diameter of the other end of the tapered hole section is equal to the hole diameter of the equal-diameter section.

In a possible implementation of the first aspect, an arc is used for transition at a joint between the other end of the tapered hole section and the one end of the equal-diameter section.

In a possible implementation of the first aspect, a distance between the one end of the equal-diameter section and the other end of the equal-diameter section ranges from 0.01 mm to 40 mm.

In a possible implementation of the first aspect, a distance between the one end of the equal-diameter section and a front end face, facing the guide sleeve, of the first object ranges from 0.1 mm to 20 mm.

In a possible implementation of the first aspect, an arc is used for transition at a joint between the other end of the equal-diameter section and the one end of the variable-diameter section.

In a possible implementation of the first aspect, a distance between the one end of the variable-diameter section and the other end of the variable-diameter section ranges from 0.1 mm to 30 mm.

According to a second aspect, this application provides an electronic device (for example, a communication device), including: a first object, where a first plug-in part is installed on the first object; a second object, where a second plug-in part is installed on the second object; and the guiding connection structure described in any one of the implementations of the first aspect, where a guide pin of the guiding connection structure is installed on the first object, a guide sleeve of the guiding connection structure is installed on the second object, and in a state in which the guide pin is inserted into the guide sleeve, accurate plugging between the first plug-in part and the second plug-in part is implemented.

In a possible implementation of the second aspect, the first object is a backplane, the second object is a pluggable module, the pluggable module is perpendicular to the backplane, the first plug-in part is a male connector, and the second plug-in part is a female connector.

### BRIEF DESCRIPTION OF DRAWINGS

FIG. 1 is a three-dimensional diagram of a communication device according to some embodiments of this application;
FIG. 2 is a locally enlarged view of a communication device according to some embodiments of this application;
FIG. 3 is a first diagram of a structure of a guide sleeve according to some embodiments of this application;
FIG. 4 is a diagram of a structure of a guide pin according to some embodiments of this application;
FIG. 5 is a first diagram of a status of plugging between a guide sleeve on a pluggable functional module and a guide pin on a backplane according to some embodiments of this application;
FIG. 6 is a second diagram of a status of plugging between a guide sleeve on a pluggable functional module and a guide pin on a backplane according to some embodiments of this application;
FIG. 7 is a second diagram of a structure of a guide sleeve according to some embodiments of this application; and
FIG. 8 is a third diagram of a status of plugging between a guide sleeve on a pluggable functional module and a guide pin on a backplane according to some embodiments of this application.

### DESCRIPTION OF EMBODIMENTS

The following describes specific implementations of this application in detail with reference to accompanying drawings.

This application provides a guiding connection structure used in an electronic device (for example, a communication device), to provide a better system guiding capability during plugging between a pluggable functional module and a backplane of a subrack, improve accuracy of alignment between connectors of the pluggable functional module and the backplane of the subrack, and ensure reliable operation of the communication device.

For example, the communication device is a communication cabinet, a base station, or another common communication device.

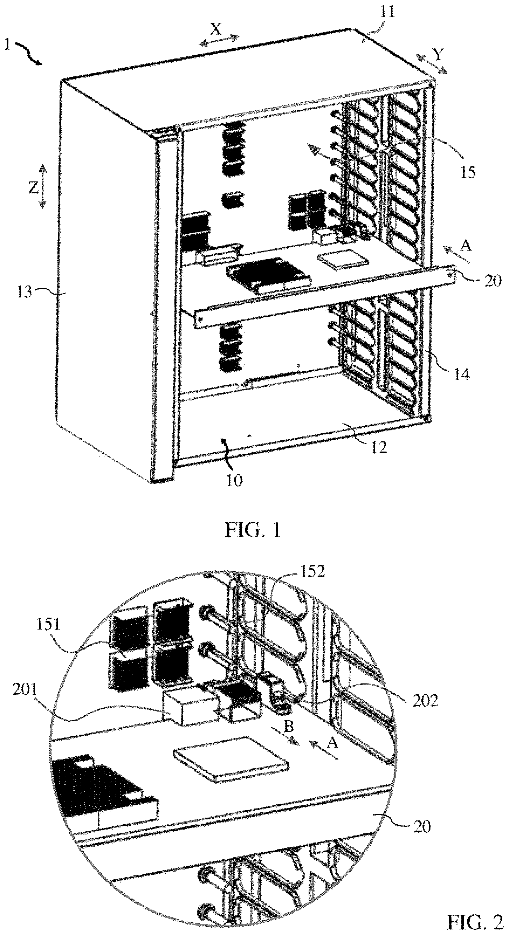

FIG. 1 is a diagram of a structure of a communication device according to an embodiment of this application. The communication device includes a subrack 1 and a pluggable functional module 20. For example, the subrack 1 includes a cavity 10, with an opening, for inserting the pluggable functional module 20. The cavity 10 of the subrack 1 is enclosed by a backplane 15, an upper subrack wall 11, a lower subrack wall 12, a left subrack wall 13, and a right subrack wall 14. The upper subrack wall 11 and the lower subrack wall 12 are arranged at a spacing along a height direction (indicated by a Z direction in FIG. 1) of the communication device. The left subrack wall 13 and the right subrack wall 14 are arranged at a spacing along a width direction (indicated by an X direction in FIG. 1) of the communication device. The backplane 15 and the opening of the cavity 10 are arranged at a spacing along a depth direction (indicated by a Y direction in FIG. 1) of the communication device.

A quantity of pluggable functional modules 20 is not limited in this application. As shown in FIG. 1, one pluggable functional module 20 is inserted into the cavity 10 of the subrack 1 through the opening of the cavity 10 (a direction A shown in FIG. 1 is an insertion direction). For example, along the insertion direction, the pluggable functional module 20 is perpendicular to the backplane 15 of the subrack 1. In some possible implementations, a plurality of pluggable functional modules 20 are inserted into the cavity 10 of the subrack 1, and the plurality of pluggable functional modules 20 are arranged at spacings along the height direction of the communication device.

FIG. 2 is a locally enlarged view of a communication device according to an embodiment of this application. A male connector 151 and a guide pin 152 are disposed on a backplane 15. A female connector 201 and a guide sleeve 202 are disposed on a pluggable functional module 20. The guide pin 152 and the guide sleeve 202 constitute a part of a guiding connection structure of a guiding system of the communication device. The guide pin 152 is inserted into the guide sleeve 202 along a direction (indicated by a direction B in FIG. 2) opposite to an insertion direction (indicated by a direction A in FIG. 2) of the pluggable functional module 20. Guiding connection between the guide pin 152 and the guide sleeve 202 implements accurate and in-place fitting between the male connector 151 on the backplane 15 and the female connector 201 on the pluggable functional module 20.

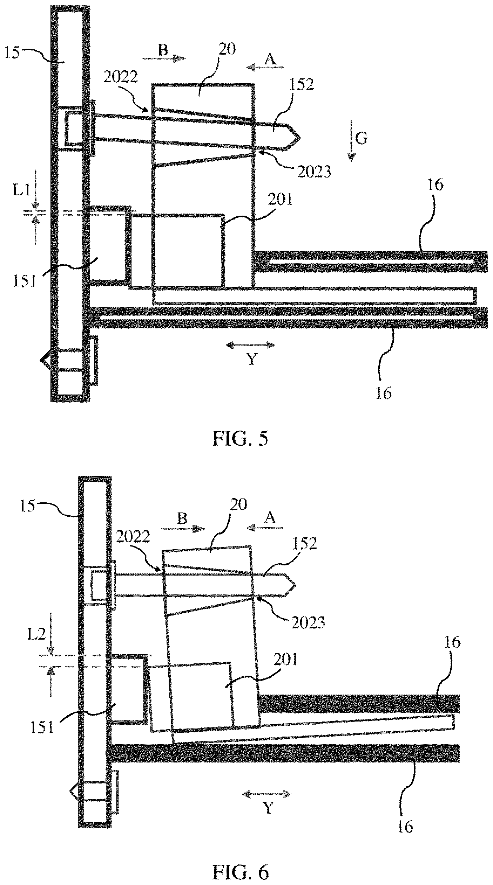

For example, a guiding system of an entire device may be divided into four stages in sequence based on a plugging and fitting process: (1) Plugging of the pluggable functional module 20 in the subrack 1 provides first-stage guiding through a guide rail 16 (as shown in FIG. 5 and FIG. 6). (2) Fitting between the guide sleeve 202 on the pluggable functional module 20 and the guide pin 152 on the backplane 15 provides second-stage guiding. (3) Guiding fitting between a housing of the female connector 201 on the pluggable functional module 20 and a housing of the male connector 151 on the backplane 15 provides third-stage guiding. (4) Guiding fitting between a hole of the female connector 201 on the pluggable functional module 20 and a pin of the male connector 151 on the backplane 15 provides fourth-stage guiding.

The second-stage guiding is key structural guiding. Quality of guiding fitting between the guide pin 152 and the guide sleeve 202 affects accurate and in-place fitting between the female connector 201 on the pluggable functional module 20 and the male connector 151 on the backplane 15.

The following describes design features of possible implementations of the guide sleeve 202 and the guide pin 152 by using examples with reference to accompanying drawings.

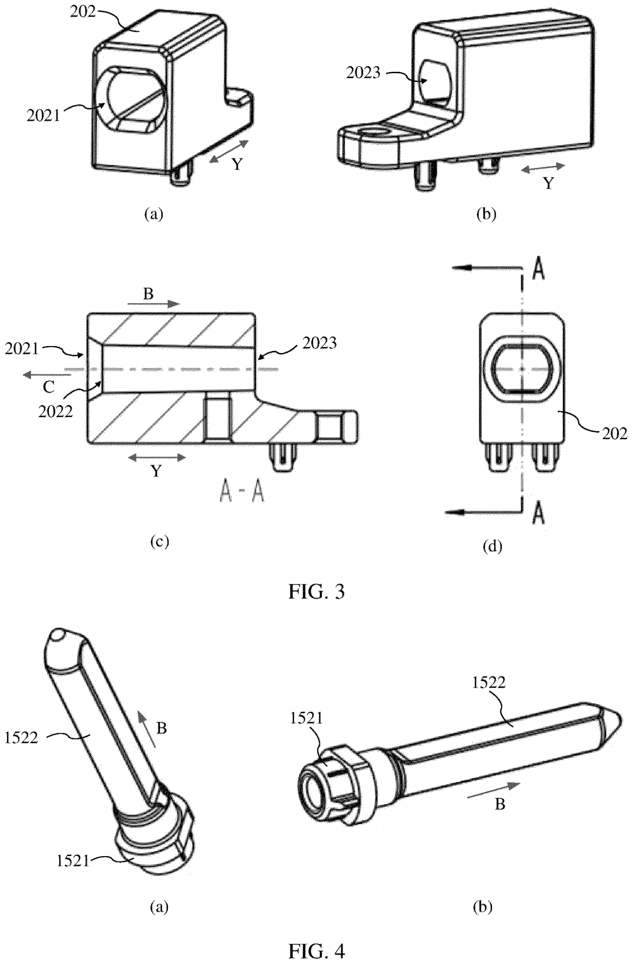

FIG. 3 is a diagram of a structure of a guide sleeve 202 according to an implementation. The guide sleeve 202 extends along a depth direction (indicated by a Y direction in (a), (b), and (c) in FIG. 3) of a communication device. The guide sleeve 202 has a guide hole for fitting with a guide pin 152. To implement a guide tolerance feature, an entrance 2021 of the guide hole of the guide sleeve 202 has a guide C corner (as shown in (a) and (c) in FIG. 3). The entrance 2021 of the guide hole of the guide sleeve 202 is located on a front end face of the guide sleeve 202, and the front end face of the guide sleeve 202 is arranged to face the backplane 15. The guide sleeve 202 is usually die-casted, for example, is mainly made of a die-casting zinc material. A mold opening solution is simple, and demolding is performed by using a slider after the guide hole is molded. A forward draft angle design consistent with an opening direction of the guide C corner is used. A direction C in FIG. 3 indicates a forward draft angle direction. In this design, an inner wall of the guide hole is smooth, a post-processing process is simple, and efficiency is high.

As shown in (c) in FIG. 3, an inner hole path of the guide hole includes a variable-diameter section, and a hole diameter of the variable-diameter section gradually decreases from one end 2022 of the section to the other end 2023 of the section. The one end 2022 of the variable-diameter section is connected to the entrance 2021 of the guide hole. When the guide pin 152 is inserted into the guide sleeve 202, the guide pin 152 is inserted into the guide hole from the entrance 2021, and is inserted into the other end 2023 of the variable-diameter section through the one end 2022 of the variable-diameter section. To be specific, a direction (a direction B shown in (c) in FIG. 3) from the one end 2022 of the variable-diameter section to the other end 2023 of the variable-diameter section is a direction along which the guide pin 152 is inserted into the guide hole of the guide sleeve 202. A hole diameter of the one end 2022 of the variable-diameter section is greater than a hole diameter of the other end 2023 of the variable-diameter section. Therefore, after the guide pin 152 is inserted into the guide sleeve 202, a gap between the guide pin 152 and the one end 2022 of the variable-diameter section is larger than a gap between the guide pin 152 and the other end 2023 of the variable-diameter section. In this way, the other end 2023 of the variable-diameter section forms a fine guide hole. To be specific, the fine guide hole is located in an intersection line between the guide hole of the guide sleeve 202 and a rear end face of the guide sleeve 202. The rear end face of the guide sleeve 202 is arranged to back the backplane 15. The rear end face of the guide sleeve 202 and the front end face of the guide sleeve 202 are located on two opposite sides of the guide sleeve 202.

FIG. 4 is a diagram of a structure of a guide pin 152 according to an implementation. The guide pin 152 extends along a depth direction of a communication device. Along an insertion direction (a direction B shown in (a) and (b) in FIG. 4) in which the guide pin 152 is inserted into a guide sleeve 202, the guide pin 152 includes an installation portion 1521 and an insertion portion 1522 for fitting with a guide hole of the guide sleeve 202. The guide pin 152 is installed on a backplane 15 through the installation portion 1521. For example, the insertion portion 1522 of the guide pin 152 is a cylinder with a tapered head. The guide pin 152 is usually die-casted, for example, is mainly made of a die-casting zinc material. In view of processing precision, a mold opening solution is simple. A solution with an upper mold and a lower mold divided along a middle line of an arc is usually used. Molding precision is high, without being affected by a draft angle.

FIG. 5 is a first diagram of a status of plugging between a guide sleeve 202 on a pluggable functional module 20 and a guide pin 152 on a backplane 15. Before a male connector 151 on the backplane 15 is in initial contact with a female connector 201 on the pluggable functional module 20, plugging and fitting between the guide pin 152 and the guide sleeve 202 are implemented. A fine guide hole of the guide sleeve 202 is located at a tail end (namely, on a rear end face) of the guide sleeve 202, and is away from a fastened end (the backplane 15) of the guide pin 152 and a fitting end face between the male connector and the female connector. Based on a deflection equation for a cantilever beam, when the guide pin 152 and the fine guide hole of the guide sleeve 202 are away from the fastened end, the guide pin 152 is deformed at a larger bending moment under impact of gravity (G shown in FIG. 5) of the pluggable functional module. Along a height direction of a communication device, a larger misalignment offset L1 occurs during contact and fitting between the male connector 151 and the female connector 201. This affects accuracy of alignment between the male connector and the female connector.

FIG. 6 is a second diagram of a status of plugging between a guide sleeve 202 on a pluggable functional module 20 and a guide pin 152 on a backplane 15. In a possible implementation, due to impact of an extreme plugging angle of the pluggable functional module 20 on a guide rail 16 of a subrack 1, a fine guide hole of the guide sleeve 202 is away from a fastened end (the backplane 15) of the guide pin 152 and a fitting end face between a male connector and a female connector, and a larger plugging angle offset L2 occurs during contact and fitting between the male connector and the female connector. This deteriorates guiding fitting during plugging between the male connector and the female connector.

Therefore, this application provides another implementation, to provide a better system guiding capability during plugging between a pluggable functional module 20 and a backplane 15 of a subrack 1, improve accuracy of alignment between a female connector 201 on the pluggable functional module 20 and a male connector 151 on the backplane 15 of the subrack 1, and ensure reliable operation of a communication device.

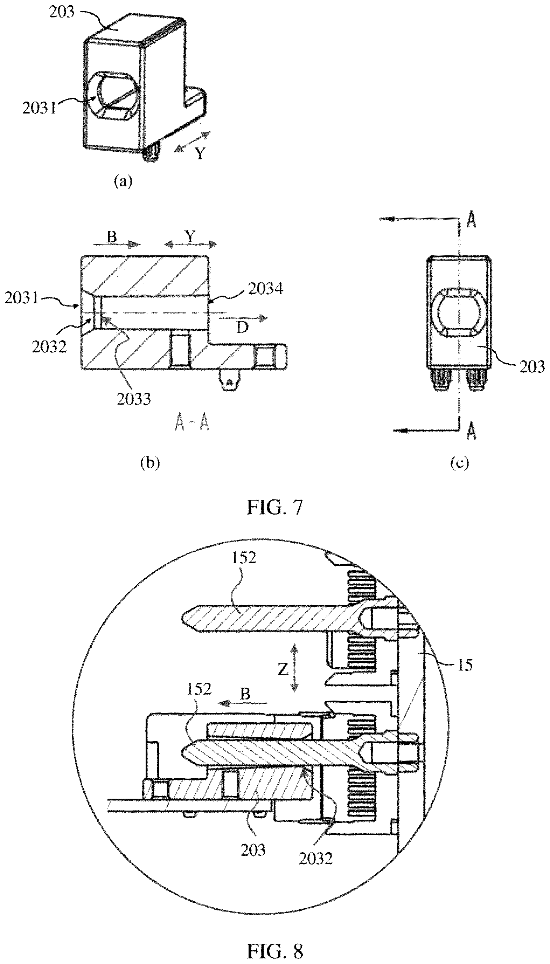

FIG. 7 is a diagram of a structure of a guide sleeve 203 according to another implementation. An inner hole path of the guide sleeve 203 shown in FIG. 7 also includes a variable-diameter section, and a reverse draft angle design is used for the variable-diameter section. A direction D in (b) in FIG. 7 shows a reverse draft angle direction. In this embodiment, a hole diameter of the variable-diameter section gradually increases from one end 2033 of the section to the other end 2034 of the section. As shown in FIG. 8, when a guide pin 152 is inserted into the guide sleeve 203, the guide pin 152 is inserted into the other end 2034 of the variable-diameter section from the one end 2033 of the variable-diameter section. To be specific, a direction (a direction B shown in (b) in FIG. 7) from the one end 2033 of the variable-diameter section to the other end 2034 of the variable-diameter section in FIG. 7 is a direction along which the guide pin 152 is inserted into a guide hole of the guide sleeve 203. A hole diameter of the one end 2033 of the variable-diameter section is less than a hole diameter of the other end 2034 of the variable-diameter section. After the guide pin 152 is inserted into the guide sleeve 203, a gap between the guide pin 152 and the one end 2033 of the variable-diameter section is smaller than a gap between the guide pin 152 and the other end 2034 of the variable-diameter section. The one end 2033 of the variable-diameter section includes a fine guide hole. A hole diameter of the fine guide hole adapts to an outer diameter of the guide pin 152, so that in a state in which the guide pin 152 is inserted into the fine guide hole (a state shown in FIG. 8), the guide pin 152 first fits into the fine guide hole, and accurate plugging between a female connector 201 on a pluggable functional module 20 and a male connector 151 on a backplane 15 of a subrack 1 is implemented.

The fine guide hole is closer to a fastened end of the guide pin 152 and an initial fitting end face between the male connector and the female connector. A distance between the fine guide hole and an initial contact end face between the male connector and the female connector is reduced. This can effectively alleviate guiding misalignment between the male connector and the female connector that is caused by bending and deformation of the guide pin 152 on the backplane 15 under effect of gravity of the pluggable functional module 20, and guiding misalignment caused by an extreme plugging deflection angle of the pluggable functional module 20 on a guide rail 16 in the subrack 1, and improve a second-stage system guiding capability, for example, improve the system guiding capability by more than 10%.

In this way, during plugging between the pluggable functional module 20 and the backplane 15 of the subrack 1, accurate alignment and installation of the female connector 201 on the pluggable functional module 20 and the male connector 151 on the backplane 15 are implemented. This ensures good contact and interconnection between signal pins of the two connectors, and implements signal transmission and communication between communication devices.

In some possible implementations, as shown in (b) in FIG. 7, the inner hole path of the guide sleeve 203 in this application further includes an equal-diameter section, and the equal-diameter section forms a fine guide hole section. A hole diameter of the equal-diameter section remains the same from one end 2032 of the section to the other end (which coincides with the one end 2033 of the variable-diameter section) of the section. The other end of the equal-diameter section is connected to the one end 2033 of the variable-diameter section. When the guide pin 152 is inserted into the guide sleeve 203, the guide pin 152 is inserted into the other end of the equal-diameter section from the one end 2032 of the equal-diameter section. The hole diameter of the equal-diameter section is equal to a hole diameter of the one end 2033 of the variable-diameter section, and adapts to the outer diameter of the guide pin 152, so that in a state in which the guide pin 152 is inserted into the equal-diameter section, accurate plugging between the male connector and the female connector is implemented. To be specific, the fine guide hole section has a specific depth, to avoid a case in which a size of the fine guide hole cannot be ensured due to a deviation of a processing process, degrading a capability of a guiding system. That is, when the guide pin 152 is inserted into the guide sleeve 203, the guide pin 152 is sequentially inserted into the equal-diameter section and the variable-diameter section.

Still as shown in (a) and (b) in FIG. 7, the inner hole path of the guide sleeve 203 further includes a tapered hole section 2031 for guiding insertion of the guide pin 152 into the equal-diameter section. That is, the inner hole path of the guide sleeve 203 shown in FIG. 7 includes a three-section structure of "the tapered hole section 2031 + the equal-diameter section + the variable-diameter section". A hole diameter of the tapered hole section 2031 gradually decreases from one end of the section to the other end (which coincides with the one end 2032 of the equal-diameter section) of the section. The other end of the tapered hole section 2031 is connected to the one end 2032 of the equal-diameter section. The tapered hole section 2031 is an entrance of the guide hole of the guide sleeve 203. The tapered hole section 2031 has a guide C corner, to implement a guide tolerance feature.

In some possible implementations, a hole diameter of the other end of the tapered hole section 2031 is equal to the hole diameter of the equal-diameter section. This facilitates transition connection between the tapered hole section 2031 and the equal-diameter section.

In some possible implementations, a transition joint between feature sections of the inner hole path of the guide sleeve 203, namely, the tapered hole section 2031, the equal-diameter section, and the variable-diameter section, may be an intersection line or an arc feature transition of any size. The arc transition can reduce a friction force between surfaces of the guide pin 152 and the guide sleeve 203 during plugging, and alleviate scraps caused by friction and other problems.

In some possible implementations, a distance between the one end 2032 of the equal-diameter section (namely, the fine guide hole section) and the other end of the equal-diameter section ranges from 0.01 mm to 40 mm. To be specific, a depth of the equal-diameter section ranges from 0.01 mm to 40 mm, including 0.01 mm and 40 mm. A shape of the fine guide hole is not limited. Any shape that can adapt to the guide pin 152 falls within the protection scope of this application. The shape of the fine guide hole may be a shape that can adapt to the guide pin 152, for example, a circular shape, an elliptic shape, a D shape, a runway shape, a rounded rectangular shape, a beveled rectangular shape, or another polygonal shape.

In some possible implementations, a distance between the one end 2032 of the equal-diameter section (namely, the fine guide hole section) and a front end face, facing the guide sleeve 203, of the backplane 15 ranges from 0.1 mm to 20 mm, including 0.1 mm and 20 mm. To be specific, a distance between a start location of the fine guide hole section and the front end face ranges from 0.1 mm to 20 mm.

In some possible implementations, a distance between the one end 2033 of the variable-diameter section and the other end 2034 of the variable-diameter section ranges from 0.1 mm to 30 mm, including 0.1 mm and 30 mm. To be specific, a depth of the variable-diameter section ranges from 0.1 mm to 30 mm. In addition, an angle of the variable-diameter section ranges from 0° to 30.0°. To be specific, an included angle between an inner wall surface of the variable-diameter section and a center line (a dashed line shown in (b) in FIG. 7) of the variable-diameter section ranges from 0° to 30°.

In some possible implementations, a processing and manufacturing method and a material of the guide sleeve 203 are not limited, and the guide sleeve 203 may be a metal casting part, a plastic injection-molded part, a machined part, or the like.

In addition, as described in the foregoing embodiments, the guide sleeve 203 is fastened to the pluggable functional module 20, and the guide pin 152 is fastened to the backplane 15. In some possible implementations, the guide sleeve 203 may alternatively be fastened to the backplane 15, and the guide pin 152 is fastened to the pluggable functional module 20. For example, the guide sleeve 203 may be directly fastened by using a screw, or may be first crimped to a PCB and then fastened by using a screw, or may be fastened through welding.

In some possible implementations, the guide sleeve 203 may be used independently, or may be integrated with a connector.

In addition, as described in the foregoing embodiments, guiding connection between the guide sleeve 203 and the guide pin 152 is used for plugging and installation of the connectors on the backplane 15 and the pluggable functional module 20. In some possible implementations, guiding connection between the guide sleeve 203 and the guide pin 152 may alternatively be used for plugging, fitting, and installation of connectors on other different pluggable modules.

To sum up, in the technical solution of the high-precision guiding connection structure in this application, a system guiding capability is improved (for example, by more than 10%) through high-precision fitting between a guide sleeve and a guide pin in a same overall system design solution. The high-precision guide sleeve structure technology can effectively ensure stability of a molding size of a fine guide hole in a low-cost die casting or injection molding design solution. A distance between the fine guide hole and an initial contact end face between a male connector and a female connector is reduced. This significantly alleviates misalignment caused by an extreme plugging angle and impact of a gravity bending moment of a pluggable functional module on the guide pin during fitting and plugging between the male connector and the female connector, and improves the system guiding capability. The system guiding capability is improved, so that system design robustness of a communication device is improved, and reliability of in-place plugging and installation of connectors is ensured. This provides a technical support capability for a product in key fields such as high-rate evolution and connector upgrading and replacement.

## Claims

1. A guiding connection structure, configured to implement mutual guiding connection between a plug-in part installed on a first object and a plug-in part installed on a second object, wherein the guiding connection structure comprises a guide pin and a guide sleeve for guiding insertion of the guide pin, wherein
the guide pin is installed on the first object, and the guide sleeve is installed on the second object; and
an inner hole path of the guide sleeve comprises a variable-diameter section, a hole diameter of the variable-diameter section gradually increases from one end of the section to the other end of the section, and when the guide pin is inserted into the guide sleeve, the guide pin is inserted into the other end of the variable-diameter section from the one end of the variable-diameter section.

2. The guiding connection structure according to claim 1, wherein the one end of the variable-diameter section comprises a fine guide hole, and a hole diameter of the fine guide hole adapts to an outer diameter of the guide pin, so that when the guide pin is inserted into the fine guide hole, accurate plugging is implemented between the plug-in part of the first object and the plug-in part of the second object.

3. The guiding connection structure according to claim 1 or 2, wherein the inner hole path of the guide sleeve further comprises an equal-diameter section, a hole diameter of the equal-diameter section remains the same from one end of the section to the other end of the section, the other end of the equal-diameter section is connected to the one end of the variable-diameter section, and when the guide pin is inserted into the guide sleeve, the guide pin is inserted into the other end of the equal-diameter section from the one end of the equal-diameter section; and
the hole diameter of the equal-diameter section is equal to a hole diameter of the one end of the variable-diameter section, and adapts to the outer diameter of the guide pin, so that when the guide pin is inserted into the equal-diameter section, accurate plugging is implemented between the plug-in part of the first object and the plug-in part of the second object.

4. The guiding connection structure according to claim 3, wherein the inner hole path of the guide sleeve further comprises a tapered hole section for guiding insertion of the guide pin into the equal-diameter section, a hole diameter of the tapered hole section gradually decreases from one end of the section to the other end of the section, and the other end of the tapered hole section is connected to the one end of the equal-diameter section.

5. The guiding connection structure according to claim 4, wherein a hole diameter of the other end of the tapered hole section is equal to the hole diameter of the equal-diameter section.

6. The guiding connection structure according to claim 4, wherein an arc is used for transition at a joint between the other end of the tapered hole section and the one end of the equal-diameter section.

7. The guiding connection structure according to claim 3, wherein a distance between the one end of the equal-diameter section and the other end of the equal-diameter section ranges from 0.01 mm to 40 mm.

8. The guiding connection structure according to claim 3, wherein a distance between the one end of the equal-diameter section and a front end face, facing the guide sleeve, of the first object ranges from 0.1 mm to 20 mm.

9. The guiding connection structure according to claim 3, wherein an arc is used for transition at a joint between the other end of the equal-diameter section and the one end of the variable-diameter section.

10. The guiding connection structure according to claim 1, wherein a distance between the one end of the variable-diameter section and the other end of the variable-diameter section ranges from 0.1 mm to 30 mm.

11. An electronic device, comprising:
a first object, wherein a first plug-in part is installed on the first object;
a second object, wherein a second plug-in part is installed on the second object; and
the guiding connection structure according to any one of claims 1 to 10, wherein a guide pin of the guiding connection structure is installed on the first object, a guide sleeve of the guiding connection structure is installed on the second object, and when the guide pin is inserted into the guide sleeve, accurate plugging is implemented between the first plug-in part and the second plug-in part.

12. The electronic device according to claim 11, wherein the first object is a backplane, the second object is a pluggable module, the pluggable module is perpendicular to the backplane, the first plug-in part is a male connector, and the second plug-in part is a female connector.
